(19) **Europäisches Patentamt**
**European Patent Office**
**Office européen des brevets**

(11) **EP 3 940 366 A1**

(12) **EUROPEAN PATENT APPLICATION**
published in accordance with Art. 153(4) EPC

(43) Date of publication:
**19.01.2022 Bulletin 2022/03**

(21) Application number: **20773916.0**

(22) Date of filing: **24.01.2020**

(51) International Patent Classification (IPC):
*G01M 99/00* (2011.01)    *H02P 29/024* (2016.01)
*G01R 31/00* (2006.01)    *G01R 31/34* (2020.01)

(52) Cooperative Patent Classification (CPC):
**G01M 99/00; G01R 31/00; G01R 31/34;**
**H02P 29/024**

(86) International application number:
**PCT/JP2020/002572**

(87) International publication number:
**WO 2020/189014 (24.09.2020 Gazette 2020/39)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **15.03.2019   JP 2019048914**
**29.11.2019   JP 2019217193**

(71) Applicant: **Omron Corporation**
**Kyoto-shi, Kyoto 600-8530 (JP)**

(72) Inventors:
• **MATSUMOTO, Toru**
**Kyoto-shi, Kyoto 600-8530 (JP)**
• **SATO, Takahiro**
**Kyoto-shi, Kyoto 600-8530 (JP)**
• **YAMADA, Tomohiro**
**Kyoto-shi, Kyoto 600-8530 (JP)**
• **YOKOTA, Koji**
**Kyoto-shi, Kyoto 600-8530 (JP)**
• **TAKATANI, Ryohei**
**Kyoto-shi, Kyoto 600-8530 (JP)**
• **TAKEUCHI, Tsuyoshi**
**Kyoto-shi, Kyoto 600-8530 (JP)**
• **IKEUCHI, Ryo**
**Kyoto-shi, Kyoto 600-8530 (JP)**

(74) Representative: **HGF**
**HGF Limited**
**1 City Walk**
**Leeds LS11 9DX (GB)**

(54) **ABNORMALITY DIAGNOSIS DEVICE AND ABNORMALITY DIAGNOSIS METHOD**

(57)    Provided is an abnormality diagnosis device capable of diagnosing an abnormality of a motor without setting many parameters. An abnormality diagnosis device (40) includes a current measuring unit (410) that measures a load current of the motor (20); a frequency analyzing unit (411) that performs frequency analysis of the load current; and a deterioration degree calculating unit (412) that calculates a degree of deterioration by adding up a preset number of intensity values from top in a preset frequency range.

FIG. 2

EP 3 940 366 A1

**Description**

TECHNICAL FIELD

The present invention relates to an abnormality diagnosis device and an abnormality diagnosis method.

BACKGROUND TECHNOLOGY

Conventionally, an abnormality in a motor in which a load imbalance has occurred is diagnosed by analyzing the FFT waveform of the drive current of the motor and detecting a sideband wave that fluctuates due to the abnormality.
For example, in Patent Document 1, an abnormality diagnosis of a motor is performed by calculating the difference between the power supply frequency level and the side wave level of the rotation frequency of the motor.

PRIOR ART DOCUMENT

PATENT DOCUMENT

Patent Document 1: Japanese Laid-Open Patent Publication No. 2010-288352

SUMMARY OF INVENTION

PROBLEMS TO BE SOLVED BY THE INVENTION

However, in the method of Patent Document 1, there are many parameters required to identify the frequency band in which the abnormality appears, and it takes time and effort to set. For example, when calculating the rotation frequency of a motor, it is necessary to set many parameters such as a drive frequency of the motor, the number of poles of the motor, and slip, etc.
The present invention has been made to solve the above problems, and an object of the present invention is to provide an abnormality diagnosis device capable of diagnosing an abnormality of a motor without setting many parameters.

MEANS TO SOLVE PROBLEMS

To solve the problem, the present invention provides an abnormality diagnostic device comprising:

a current measuring unit that measures a load current of a motor;
a frequency analyzing unit that performs frequency analysis of the load current; and
a deterioration degree calculating unit that calculates a degree of deterioration by adding up intensity values set in advance from top in a preset frequency range.

Further, to solve the problem, the present invention provides an abnormality diagnosis method comprising:

a step of measuring a load current of a motor by a current measuring unit;
a step of performing frequency analysis of the load current by a frequency analyzing unit; and
a step of calculating a degree of deterioration by adding up intensity values set in advance from top in a preset frequency range by a deterioration degree calculating unit.

EFFECT OF THE INVENTION

According to the present invention, it is possible to provide an abnormality diagnosis device capable of diagnosing an abnormality of a motor without setting many parameters.

BRIEF DESCRIPTION OF DRAWINGS

Fig. 1 is a diagram showing a schematic configuration of an abnormality diagnosis system according to an embodiment of the present invention.

Fig. 2 is a block diagram showing a hardware configuration of an abnormality diagnosis device.

Fig. 3A is a diagram showing an example of an original waveform of an FFT waveform of a drive current in a motor in which a load imbalance has occurred.

Fig. 3B is a diagram showing an example of a waveform after removing a DC component and harmonics from the FFT waveform shown in Fig. 3A.

Fig. 4 is a flowchart showing a deterioration degree calculation process by an abnormality diagnosis device.

Fig. 5 is a diagram showing a load current when the motor is normal and when an abnormality occurs due to imbalance.

Fig. 6 is a diagram showing a load current when the motor is normal and when an abnormality occurs due to cavitation.

Fig. 7 is a diagram showing a load current when the motor is normal and when an abnormality occurs due to bearing deterioration.

Fig. 8 is a diagram showing a state in which noises due to an influence of inverter drive and minute noises generated by other factors are generated in a signal to be detected.

Fig. 9 is a flowchart showing a deterioration degree calculation process by an abnormality diagnosis device of a second embodiment.

Fig. 10 is a diagram showing a load current when the motor is normal and when an abnormality occurs due to imbalance.

DESCRIPTION OF EMBODIMENT

Hereinafter, embodiments of the present invention will be described in detail with reference to the drawings.

(First Embodiment)

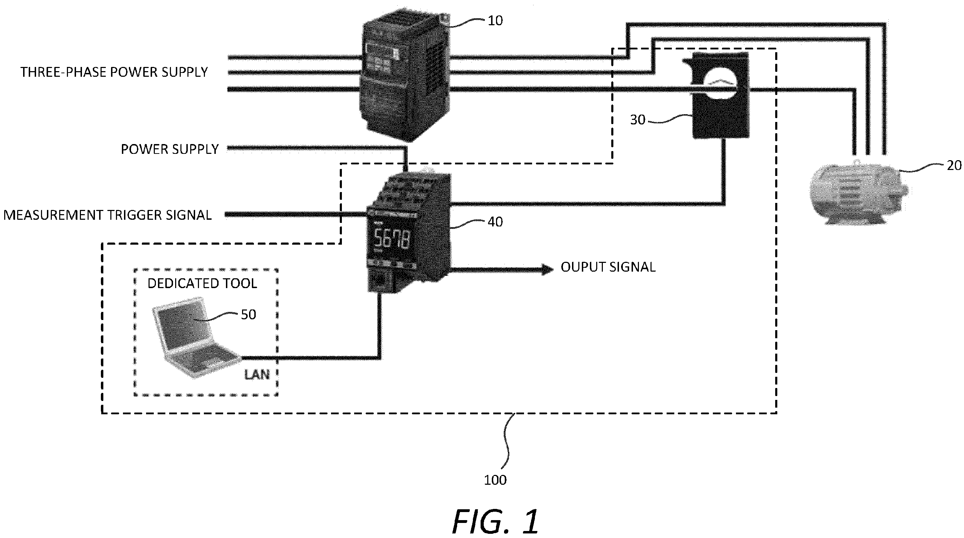

First, the first embodiment of the present invention will be described in detail with reference to the drawings. Fig. 1 is a diagram showing a schematic configuration of an abnormality diagnosis system 100 according to the present embodiment. As shown in Fig. 1, the abnormality diagnosis system 100 includes a current sensor 30, an abnormality diagnosis device 40, and a dedicated tool 50. The abnormality diagnosis system 100 is a system for diagnosing an abnormality of the motor 20 connected to the inverter 10.

The inverter 10 is connected to a three-phase power supply and combines an AC-DC converter that converts three-phase alternating current into direct current and a DC-AC inverter to convert three-phase alternating current into an arbitrary frequency and voltage. By using the inverter 10, the phase and frequency of the drive current are changed according to the rotation position of the rotor of the motor 20, so that high drive efficiency and smooth rotation with less vibration can be realized from low speed to high speed. The inverter 10 is not an essential component, and the abnormality diagnosis system 100 of the present embodiment can be realized even if the inverter 10 is not provided.

The motor 20 is a three-phase motor and is driven by three-phase alternating current from the inverter 10. The motor 20 includes a stator and a rotor (not shown). The rotor rotates a rotating shaft supported by bearings.

The current sensor 30 is a sensor that measures the load current of the motor 20. The current sensor 30 is connected to the abnormality diagnosis device 40, and the load current of the motor 20 measured by the current sensor 30 is input to the abnormality diagnosis device 40.

The abnormality diagnosis device 40 includes a current measuring unit that measures the load current of the motor 20, a frequency analyzing unit that performs frequency analysis of the load current, and an abnormality determination unit that adds up a preset number of intensity values set in advance from top in a preset frequency range to calculate the degree of deterioration. Details of the abnormality diagnosis device 40 will be described later.

The dedicated tool 50 is a device connected to the abnormality diagnosis device 40 by a LAN or the like, and is composed of, for example, a personal computer or the like. By connecting the dedicated tool 50 to the abnormality diagnosis device 40, it becomes possible to monitor the state of the motor 20. The dedicated tool 50 is not an essential component, and the abnormality diagnosis system 100 of the present embodiment can be realized even if the dedicated tool 50 is not provided.

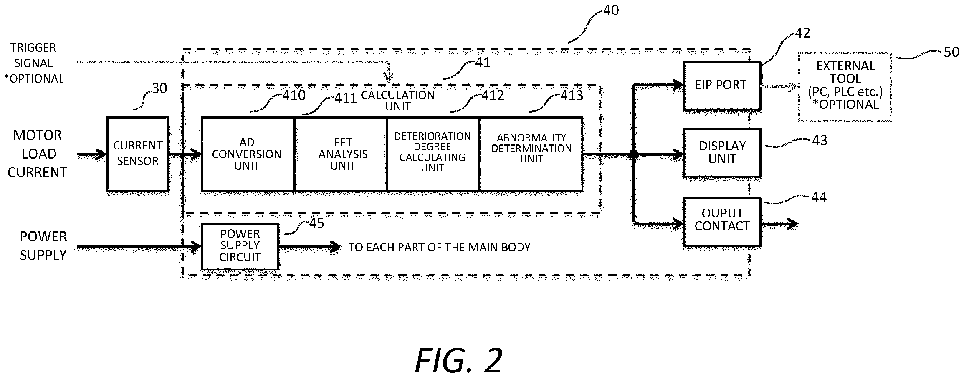

Fig. 2 shows the hardware configuration of the abnormality diagnosis device 40. As shown in Fig. 2, the abnormality diagnosis device 40 includes a calculation unit 41, an EIP port 42, a display unit 43, an output contact 44, and a power supply circuit 45.

The calculation unit 41 has the functions of an AD conversion unit 410, an FFT analysis unit 411, a deterioration degree calculating unit 412, and the abnormality determination unit 413. The AD conversion unit 410 functions as a current measuring unit that carries out AD conversion of the load current of the motor 20 detected by the current sensor 30. The FFT analysis unit 411 functions as a frequency analyzing unit for performing frequency analysis of the load current. The deterioration degree calculating unit 412 calculates the deterioration degree by adding up a preset number of the intensity values set in advance from top in a preset frequency range. The abnormality determination unit 413 has a function as an input unit for inputting a threshold value and a function as an abnormality determination unit for determining whether or not the motor 20 has deteriorated by comparing the input threshold value with the degree of deterioration. The threshold value is input from, for example, the dedicated tool 50.

The EIP port 42 is a port for enabling communication between the abnormality diagnosis device 40 and the dedicated tool 50 by the EtherNet/IP network protocol.

The display unit 43 is composed of, for example, electronic paper or the like, and displays the degree of deterioration or the like calculated by the abnormality diagnosis device 40.

The output contact 44 is a contact for transmitting the output of the abnormality diagnosis device 40 to an external device.

The power supply circuit 45 is a circuit that is connected to an external power supply and supplies the power supply necessary for the operation of each part of the abnormality diagnosis device 40.

(Abnormal diagnosis method)

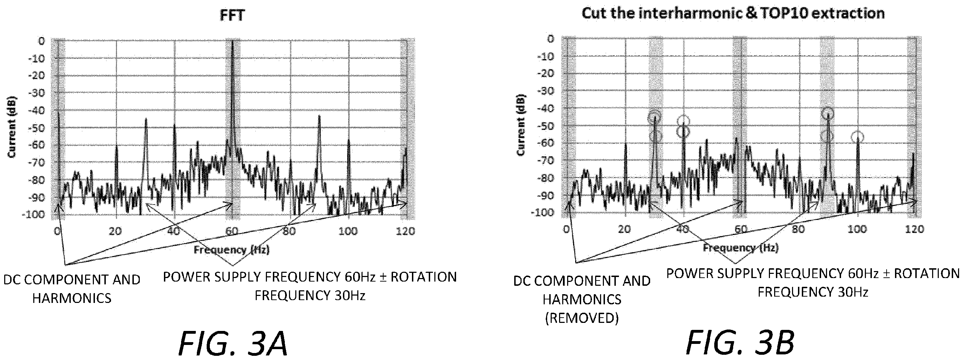

Fig. 3A is a diagram showing an example of the original waveform of the FFT waveform of the drive current in the motor in which the load imbalance has occurred. Fig. 3B is a diagram showing an example of the waveform after removing a DC component and harmonics from the FFT waveform shown in Fig. 3A.

In the present embodiment, the DC component and harmonics that have fluctuations not caused by the abnormality of the motor 20 are removed from the FFT waveform of the drive current of the motor 20, and the preset number of data are added up. This saves the trouble of setting necessary for identifying the sideband wave, and can identify the deterioration and failure of the motor 20.

For example, in the FFT waveform of the drive current of the motor 20 in which the load imbalance has occurred as shown in Fig. 3A, the fluctuations of the DC component and the harmonics are large, so the value added up due to factors other than the abnormality of the motor 20 is fluctuated if adding up the amplitudes. Therefore, conventionally, it has been necessary to specify a frequency obtained by adding the rotation frequency to the power supply frequency and a frequency obtained by subtracting the rotation frequency from the power supply frequency.

However, in the present embodiment, as shown in Fig. 3B, by removing the DC component and the harmonics, the change in the frequency component (= power supply frequency $\pm$ rotation frequency) due to the abnormality of the motor 20 becomes remarkable. As a result, the abnormality of the motor 20 can be quantified only by adding up the amplitudes.

(Abnormal diagnosis processing)

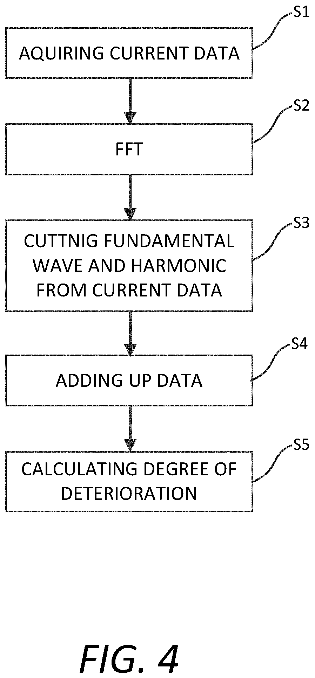

Fig. 4 is a flowchart showing a deterioration degree calculation process by the abnormality diagnosis device 40 of the present embodiment. First, the AD conversion unit 410 of the abnormality diagnosis device 40 acquires the load current of the motor 20 by the current sensor 30 (Fig. 4: S1).

Next, the FFT analysis unit 411 of the abnormality diagnosis device 40 performs frequency-analysis of the load current by the discrete Fourier transform (Fig. 4: S2).

Next, the deterioration degree calculating unit 412 of the abnormality diagnosis device 40 cuts the fundamental wave and the harmonic from the current data (Fig. 4: S3).

Next, the deterioration degree calculating unit 412 of the abnormality diagnosis device 40 calculates the deterioration degree by adding up a preset number of the intensity values set in advance from top(Fig. 4: S4). Specifically, the deterioration degree calculating unit 412 adds up, for example, the intensity values of the top 10 noises, divides the added intensity values by all the signal values, and multiplies the coefficient for adjusting the sensitivity to calculate the degree of deterioration. The formula for calculating the degree of deterioration is shown in (Equation 1).

```
(Equation 1)

Degree of deterioration = A X [(Added up Intensity

values of the Top N noises)/signal values]
```

In the above equation, N indicates the number of data to be added up, and A indicates the coefficient for adjusting the sensitivity.

After that, the abnormality determination unit 413 of the abnormality diagnosis device 40 may perform the abnormality determination by comparing the threshold value with the calculated deterioration degree.

(Degradation degree calculation process)

Next, the calculation process of the degree of deterioration in this embodiment will be described. In the following example, the number of poles of the motor 20 is four, and the power supply frequency of 60 Hz is directly driven.

The appearance of the abnormality of the motor 20 differs depending on the failure mode. Therefore, in the present embodiment, three methods for calculating the degree of deterioration are provided according to the failure mode.

The first failure mode is a failure mode due to unbalance, misalignment, or breakage of the rotor bar. The second failure mode is a failure mode due to cavitation. The third failure mode is a failure mode due to bearing deterioration. Hereinafter, the processing for calculating the degree of deterioration in each failure mode will be described.

(First failure mode)

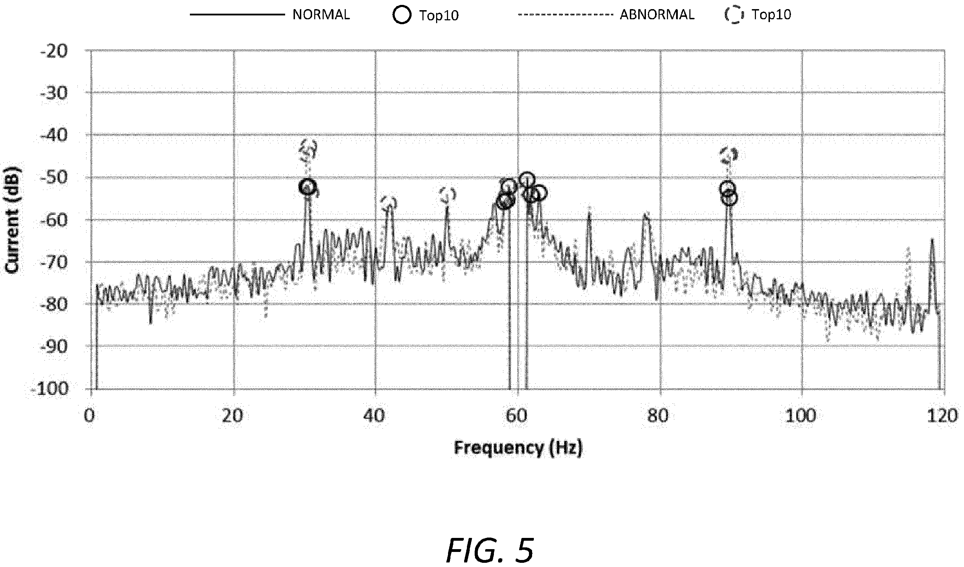

As an example, the calculation process of the degree of deterioration in the case of a failure mode due to imbalance will be described. Fig. 5 is a diagram showing load currents when the motor 20 is normal and when an abnormality occurs due to imbalance.

In this example, the FFT analysis unit 411 performs FFT with a resolution of 0.25 Hz, and in the frequency range of 0 Hz to second harmonic (0 Hz to 120 Hz), the top 10 of intensity values are added up. Then, the degree of deterioration is calculated by the following equation.

(Equation 2)

$$\text{Degree of deterioration} = 600 \times [(\text{Added up Intensity values of noises of Frequency}_{\text{0-secondary harmonic}})/\text{signal values}]$$

However, the top 10 are just examples, and the strength values of 6 to 20 may be added up.

As can be seen from Fig. 5, in this case, the intensity values of the fundamental frequency $\pm$ the rotation frequency increase, and under the conditions of this example, in the case of an abnormality, the intensity values of 30 Hz and 90 Hz increase. Further, in this case, the degree of deterioration in the normal case was 13, and the degree of deterioration in the abnormal case was 22. Therefore, by setting the threshold value to 20, the abnormality determination unit 413 can determine the abnormality.

(Second failure mode)

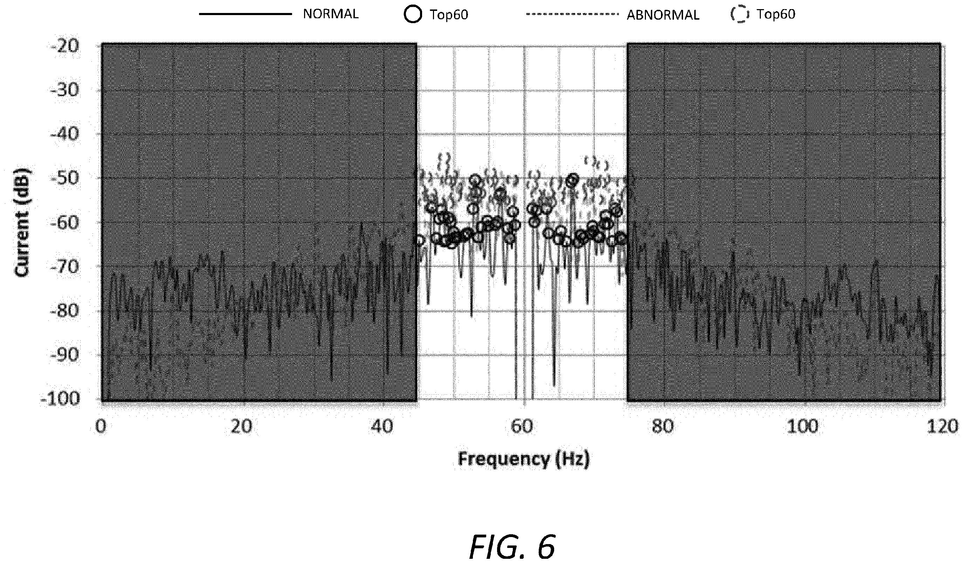

As an example, the calculation process of the degree of deterioration in the case of the failure mode due to cavitation will be described. Fig. 6 is a diagram showing a load current when the motor 20 is normal and when an abnormality occurs due to cavitation.

In this example, the FFT analysis unit 411 performed an FFT with a resolution of 0.25 Hz, and in the frequency range of the fundamental frequency $\pm$ 15 Hz, the top 60 intensity values were added up, and the degree of deterioration was calculated by the following equation.

(Equation 3)

$$\text{Degree of deterioration} = 200 \times [(\text{Added up Intensity values of noises of Frequency}_{\pm 15\text{Hz}})/\text{signal values}]$$

However, the top 60 pieces are just an example, and the number may be changed as appropriate and the strength values may be added up.

As can be seen from Fig. 6, in this case, the intensity values within the fundamental frequency $\pm$ 15 Hz increase, and in the case of abnormality, the intensity values of 45 Hz to 75 Hz increase. Further, in this case, the degree of deterioration in the normal case was 13, and the degree of deterioration in the abnormal case was 30. Therefore, by setting the threshold value to 20, the abnormality determination unit 413 can determine the abnormality.

(Third failure mode)

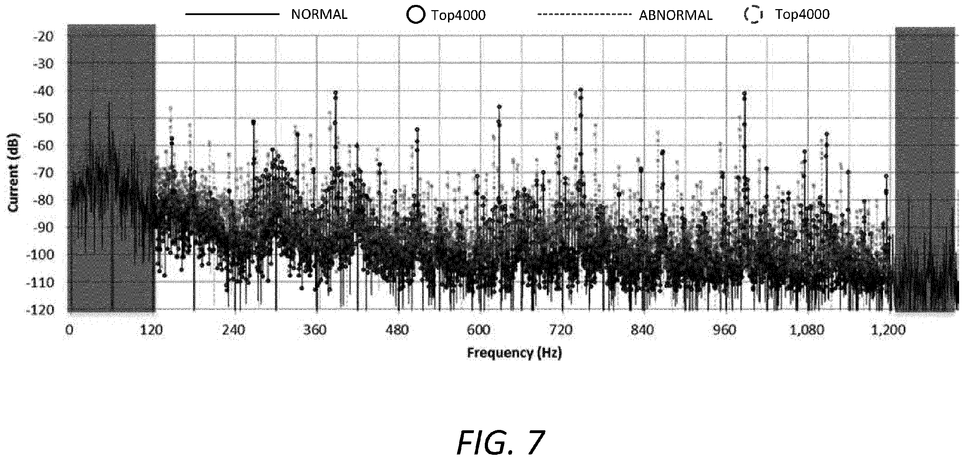

As an example, the process of calculating the degree of deterioration in the case of a failure mode due to bearing deterioration will be described. Fig. 7 is a diagram showing a load current when the motor 20 is normal and when an abnormality occurs due to bearing deterioration.

In this example, the FFT analysis unit 411 performs an FFT with a resolution of 0.25 Hz, and in the frequency range of the second harmonic to the twentieth harmonic (120 Hz to 1200 Hz), the top 4000 intensity values are added up. Then, the degree of deterioration is calculated by the following equation.

(Equation 4)

Degree of deterioration = 100 X [(Added up Intensity values of noises of Frequency$_{2nd-20th\ harmonic}$)/signal values]

However, the top 4000 pieces are an example, and the number may be changed as appropriate and the strength values may be added up.

As can be seen from Fig. 7, in this case, the intensity values of the second harmonic to the 20th harmonic increase, and under the conditions of this example, in the case of an abnormality, the intensity values of 120 Hz to 1200 Hz increase. Further, in this case, the degree of deterioration in the normal case was 20, and the degree of deterioration in the abnormal case was 30. Therefore, by setting the threshold value to 25, the abnormality determination unit 413 can determine the abnormality.

As described above, according to the present embodiment, the degree of deterioration is calculated by adding up the intensity values of the preset numbers from top in the preset frequency range, so that it is possible to perform abnormality diagnosis of the motor without setting many parameters such as a drive frequency of the motor, a number of poles of the motor, and slippage, etc.

(Second Embodiment)

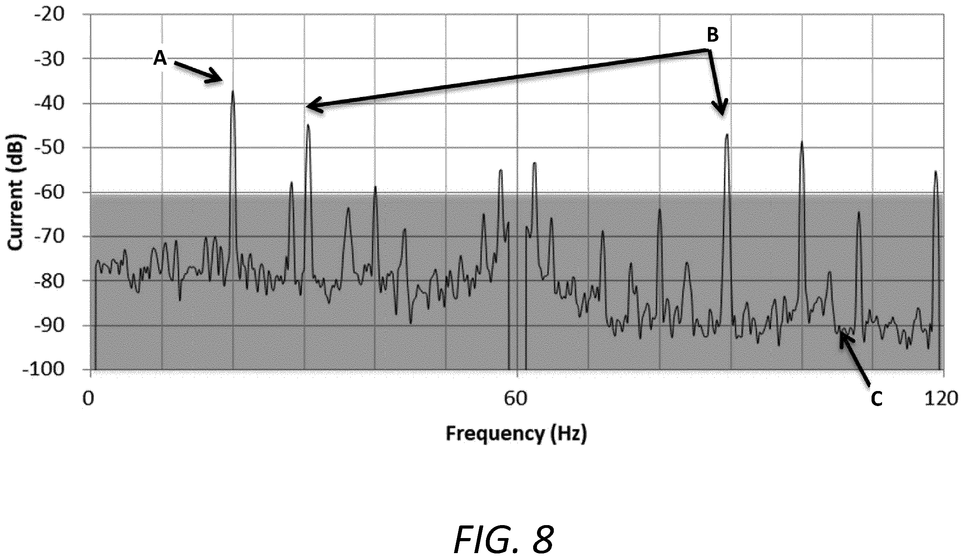

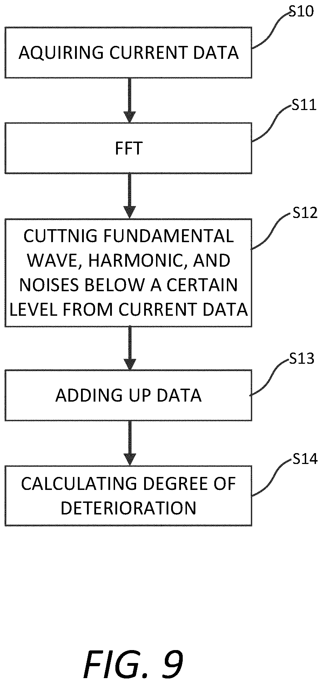

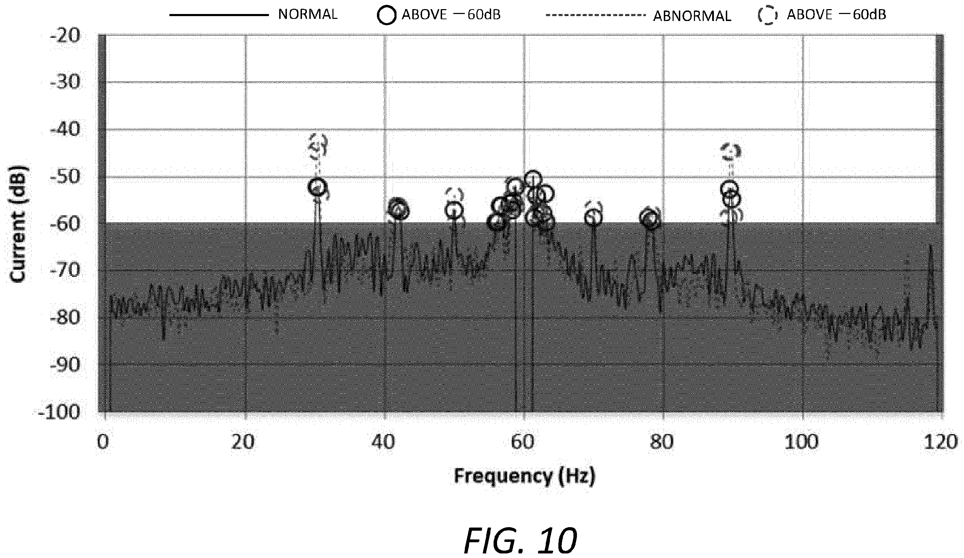

Next, the second embodiment of the present invention will be described in detail with reference to the drawings. Fig. 8 is a diagram showing a state in which noises due to the influence of inverter drive and minute noises generated by other factors are generated in the signal to be detected in the present embodiment. Fig. 9 is a flowchart showing a deterioration degree calculation process by the abnormality diagnosis device of the present embodiment. Fig. 10 is a diagram showing load currents when the motor is normal and when an abnormality occurs due to imbalance in the present embodiment.

In the above-described first embodiment, an embodiment in which a predetermined number of intensity values are added up to calculate the degree of deterioration has been described. On the other hand, in the present embodiment, an embodiment in which the degree of deterioration is calculated by adding up the intensity values above a certain level will be described.

As shown in Fig. 8, due to the influence of the inverter drive, noises larger than the signal to be detected may be generated. In Fig. 8, the arrow A indicates the noises generated by the influence of the inverter drive.

In this case, for example, if the intensity values are added up with a small number such as the top 10, the top 10 may contain a lot of noises due to the influence of the inverter, and the sensitivity for detecting a signal due to an abnormality may decrease.

The noise intensity values due to the influence of inverter drive differ depending on the control method of the inverter used, the manufacturer, etc., so it cannot be removed uniformly. Therefore, it is conceivable to add up more intensity values instead of adding up a certain number of intensity values from the top.

However, as shown in Fig. 8, in addition to the noises due to the influence of the inverter drive, there is minute noises generated by other factors. Fig. 8 is a diagram showing a state in which noises due to the influence of inverter drive and minute noises generated by other factors are generated in the signal to be detected. In Fig. 8, an arrow C indicates minute noises generated by other factors. The intensity values of these minute noises are highly random, and when a larger number of intensity values are added together, a large amount of minute noises may be included. Then, the sensitivity for detecting a signal due to an abnormality may decrease.

Therefore, in the present embodiment, it is decided to remove signals below a certain level and add up intensity values above a certain level to calculate the degree of deterioration. However, as a result of the experiment, it is known that the noises due to the abnormality has an intensity value of -50 dB or more. Therefore, in the present embodiment, for example, by taking a margin of -10 dB and adding up the intensity values of -60 dB or more, it is decided to add up all the remaining signals after removing minute noises. As a result, it was confirmed that the signals to be detected can be surely added up after removing minute noises, and the deterioration tendency can be detected.

The noises generated by the influence of the inverter drive are constant regardless of the abnormality, but the signal to be detected changes depending on the abnormality. However, according to the present embodiment, by adding up the intensity values of a certain level or higher, it is possible to obtain a sufficient number of intensity values of the signals to be detected, and it is possible to prevent a decrease in sensitivity for detecting signals due to an abnormality.

The hardware configuration of the abnormality diagnosis device 40 in the present embodiment is the same as the configuration of the abnormality diagnosis device 40 in the first embodiment shown in Fig. 2 when shown in the block diagram. However, the abnormality diagnosis device 40 of the present embodiment does not calculate the degree of deterioration by adding up the number of intensity values preset from top, but calculates the degree of deterioration by adding up the intensity values of a certain level or higher set in advance.

The abnormality diagnosis device 40 of the present embodiment includes a calculation unit 41, an EIP port 42, a display unit 43, an output contact 44, and a power supply circuit 45, as in the first embodiment. The deterioration degree calculating unit 412 in the present embodiment is different from the first embodiment in that the deterioration degree calculating unit 412 calculates the deterioration degree by adding up the intensity values of a certain level or higher in a preset frequency range. Other configurations are the same as those in the first embodiment.

(Abnormal diagnosis processing)

Fig. 9 is a flowchart showing a deterioration degree calculation process by the abnormality diagnosis device 40 of the present embodiment. First, the AD conversion unit 410 of the abnormality diagnosis device 40 acquires the load current of the motor 20 by the current sensor 30 (Fig. 9: S10).

Next, the FFT analysis unit 411 of the abnormality diagnosis device 40 performs frequency-analysis of the load current by the discrete Fourier transform (Fig. 9: S11).

Next, the deterioration degree calculating unit 412 of the abnormality diagnosis device 40 cuts the fundamental wave and the harmonic from the current data, and further cuts the noises below a certain level (Fig. 9: S12).

Next, the deterioration degree calculating unit 412 of the abnormality diagnosis device 40 calculates the deterioration degree by adding up the intensity values set in advance from top (Fig. 9: S13). Specifically, the deterioration degree calculating unit 412 removes noises of less than -60 dB, for example, and adds up the intensity values of all the remaining noises. Then, the deterioration degree calculating unit 412 divides the combined intensity values by all the signal values, and calculate the degree of deterioration by multiplying the coefficient for adjusting the sensitivity. The equation for calculating the degree of deterioration is the same as that shown in (Equation 1) described in the first embodiment.

After that, the abnormality determination unit 413 of the abnormality diagnosis device 40 may perform the abnormality determination by comparing the threshold value with the calculated deterioration degree.

(Degradation degree calculation process)

Next, the calculation process of the degree of deterioration in this embodiment will be described. In the following example, the number of poles of the motor 20 is four, and the power supply frequency of 60 Hz is directly driven.

In this embodiment, as an example, a process of calculating the degree of deterioration in the case of a failure mode due to imbalance will be described. Fig. 10 is a diagram showing load currents when the motor 20 is normal and when an abnormality occurs due to imbalance.

In this example, the FFT analysis unit 411 performs FFT with a resolution of 0.25 Hz, and in the frequency range of 0 Hz to second harmonic (0 Hz to 120 Hz), and adds up the intensity values of -60 dB or more. Then, it calculates the degree of deterioration by the following equation.

(Equation 5)

Degree of deterioration = 600 X [(Added up Intensity values of noises of Frequency$_{0\text{-secondary harmonic}}$)/signal values]

As can be seen from Fig. 10, in this case, the intensity values of the fundamental frequency $\pm$ the rotation frequency increase, and under the conditions of this example, in the case of an abnormality, the intensity values of 30 Hz and 90 Hz increase. Further, in this case, the degree of deterioration in the normal case was 24, and the degree of deterioration in the abnormal case was 33. Therefore, by setting the threshold value to 30, the abnormality determination unit 413 can determine the abnormality.

It may be combined with the first embodiment. When the present embodiment and the first embodiment are combined, the abnormality diagnosis device 40, particularly the deterioration degree calculating unit 412 may have a function of calculating the degree of deterioration by adding up the intensity values of a preset numbers of a certain level or higher in a preset frequency range from top.

(Modification example)

The above embodiment is an example, and various modifications can be made without departing from the scope of the present invention.

In the above-described embodiment, a mode in which the load current waveforms output in 4 seconds are added up every 4 seconds has been described. However, the present invention is not limited to such an aspect, and a total period for adding up can be appropriately determined in consideration of the amount of data and the accuracy.

Although the abnormality diagnostic apparatus and the abnormality diagnosis method according to the embodiment of the present invention have been described in the present specification, the present invention is not limited thereto, and various modifications can be made without departing from the gist of the present invention.

EXPLANATION OF SYMBOLS

| | |
|---|---|
| 10 | inverter |
| 20 | motor |
| 30 | current sensor |
| 40 | abnormality diagnostic device |
| 41 | calculation unit |
| 42 | EIP port |
| 43 | display unit |
| 44 | output contacts |
| 50 | dedicated tool |
| 100 | abnormality diagnosis system |
| 410 | AD conversion unit |
| 411 | FFT analysis department |
| 412 | deterioration degree calculating unit |
| 413 | abnormality determination unit |

**Claims**

1. An abnormality diagnostic device **characterized in that** the device comprises:

   a current measuring unit that measures a load current of a motor;
   a frequency analyzing unit that performs frequency analysis of the load current; and
   a deterioration degree calculating unit that calculates a degree of deterioration by adding up intensity values set in advance from top in a preset frequency range.

2. The abnormality diagnostic device according to claim 1, **characterized in that**
   the deterioration degree calculating unit calculates the deterioration degree by adding up a preset number of intensity values above a certain level from top.

3. The abnormality diagnostic device according to claim 1 or 2, **characterized in that**
   the deterioration degree calculating unit calculates the deterioration degree by adding up the intensity values of 6 to 20 pieces from top.

4. The abnormality diagnostic device according to claim 3, **characterized in that**
the deterioration degree calculating unit preferably calculates the deterioration degree by adding up 10 pieces of the intensity values from top.

5. The abnormality diagnostic device according to any one of claims 1 to 4, **characterized in that**

the frequency analyzing unit performs frequency analysis with a resolution of 0.25 Hz, wherein
the deterioration degree calculating unit calculates the deterioration degree in the frequency range of 0 Hz to a second harmonic.

6. The abnormality diagnostic device according to claim 1, **characterized in that**

the frequency analyzing unit performs frequency analysis with a resolution of 0.25 Hz, wherein
the deterioration degree calculating unit calculates the deterioration degree in the frequency range of fundamental frequency $\pm$ 15 Hz.

7. The abnormality diagnostic device according to claim 1, **characterized in that**
the deterioration degree calculating unit preferably calculates the deterioration degree by adding up 60 pieces of intensity values from top.

8. The abnormality diagnostic device according to any one of claims 1 to 4, **characterized in that**

the frequency analyzing unit performs frequency analysis with a resolution of 0.25 Hz, wherein
the deterioration degree calculating unit calculates the deterioration degree in the frequency range of a second harmonic to a twentieth harmonic.

9. The abnormality diagnostic device according to claim 8, **characterized in that**
the deterioration degree calculating unit preferably calculates the deterioration degree by adding up 4000 pieces of intensity values from top.

10. The abnormality diagnostic device according to claim 8, **characterized in that**
the deterioration degree calculating unit excludes the intensity values at fundamental frequency and harmonics from the deterioration degree calculation.

11. The abnormality diagnostic device according to any one of claims 1 to 9, **characterized in that** the device further comprises:

an input unit that inputs a threshold value; and
an abnormality determination unit that determines whether or not the motor has deteriorated by comparing the threshold value with the degree of deterioration.

12. An abnormality diagnostic device, **characterized in that** the device comprises:

a current measuring unit that measures a load current of a motor;
a frequency analyzing unit that performs frequency analysis of the load current; and
a deterioration degree calculating unit that calculates a degree of deterioration by adding up intensity values above a certain level in a preset frequency range.

13. The abnormality diagnostic device according to claim 12, **characterized in that**

the frequency analyzing unit performs frequency analysis with a resolution of 0.25 Hz, wherein
the deterioration degree calculating unit calculates the deterioration degree in the frequency range of 0 Hz to a second harmonic.

14. An abnormality diagnostic method **characterized in that** the method comprises:

a step of measuring a load current of a motor by a current measuring unit;
a step of performing frequency analysis of the load current by a frequency analyzing unit; and

a step of calculating a degree of deterioration by adding up intensity values set in advance from top in a preset frequency range by a deterioration degree calculating unit.

15. An abnormality diagnostic method, **characterized in that** the method comprises:

a step of measuring a load current of a motor by a current measuring unit;
a step of performing frequency analysis of the load current by a frequency analyzing unit; and
a step of calculating a degree of deterioration by adding up intensity values above a certain level in a preset frequency range by a deterioration degree calculating unit.

THREE-PHASE POWER SUPPLY

POWER SUPPLY

MEASUREMENT TRIGGER SIGNAL

DEDICATED TOOL

50

LAN

10

30

20

40

OUPUT SIGNAL

100

FIG. 1

EP 3 940 366 A1

FIG. 2

FIG. 3B

FIG. 3A

*FIG. 4*

EP 3 940 366 A1

*FIG. 5*

EP 3 940 366 A1

*FIG. 6*

EP 3 940 366 A1

**FIG. 7**

*FIG. 8*

```
                                                    ┌─ S10
        ┌──────────────────────────┐
        │   AQUIRING CURRENT DATA  │
        └──────────────────────────┘
                    │
                    ▼                               ┌─ S11
        ┌──────────────────────────┐
        │           FFT            │
        └──────────────────────────┘
                    │
                    ▼                               ┌─ S12
        ┌──────────────────────────┐
        │   CUTTNIG FUNDAMENTAL    │
        │   WAVE, HARMONIC, AND    │
        │  NOISES BELOW A CERTAIN  │
        │ LEVEL FROM CURRENT DATA  │
        └──────────────────────────┘
                    │
                    ▼                               ┌─ S13
        ┌──────────────────────────┐
        │      ADDING UP DATA      │
        └──────────────────────────┘
                    │
                    ▼                               ┌─ S14
        ┌──────────────────────────┐
        │  CALCULATING DEGREE OF   │
        │      DETERIORATION       │
        └──────────────────────────┘
```

*FIG. 9*

*FIG. 10*

<table>
<tr><td colspan="2"><b>INTERNATIONAL SEARCH REPORT</b></td><td>International application No.<br>PCT/JP2020/002572</td></tr>
</table>

**A. CLASSIFICATION OF SUBJECT MATTER**
G01M 99/00(2011.01)i; H02P 29/024(2016.01)i; G01R 31/00(2006.01)i; G01R 31/34(2020.01)i
FI: G01R31/34 A; G01R31/00; H02P29/024; G01M99/00 A

According to International Patent Classification (IPC) or to both national classification and IPC

**B. FIELDS SEARCHED**

Minimum documentation searched (classification system followed by classification symbols)
G01M99/00; H02P29/024; G01R31/00; G01R31/34

Documentation searched other than minimum documentation to the extent that such documents are included in the fields searched
| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2016-90546 A (ASAHI KASEI ENGINEERING CORPORATION) 23.05.2016 (2016-05-23) paragraphs [0022]-[0041], fig. 1-3A | 1,5-6,8,11,14<br>2,12-13,15<br>3-4,7,9-10 |
| Y<br>A | JP 11-51989 A (FUJITSU TEN LTD.) 26.02.1999 (1999-02-26) paragraphs [0007]-[0013], fig. 1-4 | 2,12-13,15<br>3-5,7,9-10 |
| A | JP 2015-215275 A (HITACHI, LTD.) 03.12.2015 (2015-12-03) entire text, all drawings | 1-11 |
| A | JP 2016-156643 A (HITACHI, LTD.) 01.09.2016 (2016-09-01) entire text, all drawings | 1-11 |
| A | JP 2009-174872 A (TOYOTA MOTOR CORP.) 06.08.2009 (2009-08-06) entire text, all drawings | 1-11 |

☐ Further documents are listed in the continuation of Box C.　　☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>　27 February 2020 (27.02.2020) | Date of mailing of the international search report<br>　10 March 2020 (10.03.2020) |
|---|---|
| Name and mailing address of the ISA/<br>　Japan Patent Office<br>　3-4-3, Kasumigaseki, Chiyoda-ku,<br>　Tokyo 100-8915, Japan | Authorized officer<br><br>Telephone No. |

Form PCT/ISA/210 (second sheet) (January 2015)

**INTERNATIONAL SEARCH REPORT**

Information on patent family members

| International application No. |
| --- |
| PCT/JP2020/002572 |

| Patent Documents referred in the Report | Publication Date | Patent Family | Publication Date |
| --- | --- | --- | --- |
| JP 2016-90546 A | 23 May 2016 | (Family: none) | |
| JP 11-51989 A | 26 Feb. 1999 | (Family: none) | |
| JP 2015-215275 A | 03 Dec. 2015 | US 2015/0331051 A1 entire text, all drawings | |
| JP 2016-156643 A | 01 Sep. 2016 | US 2016/0245851 A1 entire text, all drawings DE 102016102328 A1 | |
| JP 2009-174872 A | 06 Aug. 2009 | (Family: none) | |

Form PCT/ISA/210 (patent family annex) (January 2015)

**REFERENCES CITED IN THE DESCRIPTION**

**Patent documents cited in the description**

- JP 2010288352 A